# EUROPEAN PATENT APPLICATION

(11) **EP 3 334 082 A1**
(43) Date of publication of application: **13.06.2018**
(21) Application number: 16202325.3
(22) Date of filing: 06.12.2016
(51) Int. Cl.: H04L 7/00, H03K 5/08, H03L 7/087, H03M 5/02, H04L 7/033, H04L 27/00

(54) **A CLOCK RECOVERY SYSTEM**

(71) Applicant: Universiteit Gent, 9000 Gent (BE)
(72) Inventor: DE KEULENAER, Timothy, 9000 Gent (BE); RAMSES, Pierco, 9000 Gent (BE); VAERNEWYCK, Renato, 9800 Deinze (BE); VYNCKE, Arno, 9050 Ledeberg (BE)
(74) Representative: DenK iP

(57) **Abstract**

A system (100) for recovering a clock signal (160) from an incoming signal (150). The system comprises at least two phase detection circuits (130), and at least one conversion block (120) per phase detection circuit (130). The conversion blocks are adapted for conditioning the incoming signal. The incoming signal (150) is a poly-binary signal or an NRZ signal. The system (100) is configured for recovering the clock signal (160) from the poly-binary signal or NRZ signal by controlling the at least one conversion block (120) and/or by controlling the phase detection circuits (130), such that in a first mode the system (100) can lock onto an incoming NRZ signal for recovering the clock signal, and in a second mode the system (100) can lock onto an incoming poly-binary signal for recovering the clock signal.

## Description

### Field of the invention

The invention relates to the field of clock recovery systems. More specifically it relates to clock recovery systems which can recover the clock from an incoming signal. The signal may be an non-return-to-zero (NRZ) signal or a poly-binary signal.

### Background of the invention

Clock recovery systems are required to recover data from an incoming data stream in case no clock signal is transmitted together with the data stream. Therefore many communication systems require a clock and data recovery (CDR) system at the receiver.

An incoming data stream can for example be a non-return-to-zero (NRZ) data stream or a poly-binary data stream (e.g. a duo-binary data stream). Prior art receivers may be implemented for receiving an NRZ data stream and other prior art receivers may be implemented for receiving a poly-binary data stream.

While both specific NRZ and duo-binary CDRs exist the implementation of both in a receiver increases the receiver complexity and needed chip area.

There is therefore room for improvement in a receiver which can receive both NRZ as well as poly-binary signals.

### Summary of the invention

It is an object of embodiments of the present invention to provide a good system for recovering a clock signal from an incoming signal wherein the incoming signal can be a poly-binary signal or an NRZ signal.

The above objective is accomplished by a method and device according to the present invention.

In a first aspect embodiments of the present invention relate to a system for recovering a clock signal from an incoming signal. The system comprises at least two phase detection circuits, and at least one conversion block per phase detection circuit. The conversion blocks are adapted for conditioning the incoming signal. The incoming signal is a poly-binary signal or an NRZ signal, and the system is configured for recovering the clock signal from the poly-binary signal or NRZ signal by controlling the at least one conversion block and/or by controlling the phase detection circuits, such that in a first mode the system can lock onto an incoming NRZ signal for recovering the clock signal, and in a second mode the system can lock onto an incoming poly-binary signal for recovering the clock signal.

In embodiments of the present invention the system can set, in the first mode, the conversion blocks such that the NRZ signal is received at the input of only one of the phase detection circuits, and/or the system can set the output of all but one phase detection circuit to zero. In the second mode the system can set the conversion blocks such that the poly-binary signal, comprising different vertical eye openings when represented in an eye diagram, can be converted by the different conversion blocks into different NRZ signals corresponding with the different vertical eye openings, such that the resulting NRZ signals can be selected by the phase detection circuits. The system comprises an output block for combining the outputs of the phase detection circuits to generate the clock signal, and the system is configured such that, in operation, the clock signal or a signal synchronous with the clock signal is used for clocking the phase detection circuits.

It is an advantage of embodiments of the present invention that the system for recovering a clock signal can lock on an NRZ signal as well as on an n-level poly-binary signal. In embodiments of the present invention the number of levels n may be equal the number of phase detection circuits + 1 (e.g. a duobinary signal has three levels and two phase detectors may be used). In embodiments of the present invention the number of levels n may be higher than the number of phase detection circuits +1. This will, however, imply that some phase information may be lost. In embodiments according to the present invention the system can switch between the first mode and the second mode by setting the conversion blocks. It is thereby an advantage of embodiments of the present invention that no hardware changes are required. Setting of the conversion blocks may be done by hardware or by software.

In embodiments of the present invention the phase detection circuits are adapted for also performing the function of de-multiplexing.

It is an advantage of embodiments of the present invention that the phase detection circuits are adapted for performing the function of de-multiplexing. In case a poly-binary signal is applied this allows to demodulate the poly-binary data-stream at a lower bitrate. It is thereby an advantage of embodiments of the present invention that the clock speed can be reduced (e.g. in case of demodulation of a duobinary signal to half the clock speed), which allows implementation with a reduced power consumption.

In embodiments of the present invention the conversion blocks comprise a comparator, and the incoming signal can be connected with a first input terminal of the comparator and a threshold signal can be connected to a second input terminal of the comparator, wherein in the first mode the system can set the threshold signals of the comparators such that the NRZ signal is received at the input of one of the phase detection circuits, and/or wherein in the first mode the system can force the output of the other comparators to zero and/or the output of the corresponding phase detection circuit to zero, wherein in the second mode the system can set the threshold signal of one or more of the comparators such that the poly-binary signal is converted in a NRZ signal which can be selected by the corresponding phase detection circuit, wherein the system comprises an output block for combining the outputs of the phase detection circuits to generate the clock signal.

It is an advantage of embodiments of the present invention that the system can be switched between poly-binary and NRZ mode by modifying the threshold signals of the comparators. It is an advantage of embodiments of the present invention that no hardware changes need to be made.

In embodiments of the present invention the system comprising one or more switches which allow to force the output of one or more of the comparators to zero.

In embodiments of the present invention the system is adapted for biasing the threshold signal of one or more of the comparators past the maximum or minimum of the NRZ signal to force the output of one or more of the comparators to zero.

In embodiments of the present invention the system is adapted for switching off the comparator and/or the phase detection circuit.

In embodiments of the present invention the phase detection circuits are adapted for delivering an error and a reference signal and the output block comprises a first combiner adapted for combining the error signals of phase detectors and a second combiner adapted for combining the reference signals of the phase detectors.

In embodiments of the present invention the output block comprises a charge pump and loop filter and a voltage controlled oscillator wherein the inputs of the charge pump and loop filter are connected with the outputs of the combiners and wherein the charge pump and loop filter are adapted for generating a tuning voltage, based on the outputs from the combiners, for the voltage controlled oscillator.

In embodiments of the present invention the system is adapted for recovering the data of the incoming signal.

In embodiments of the present invention the poly-binary signal is a duo-binary signal.

In a second aspect embodiments of the present invention relate to a receiver comprising a system in accordance with embodiments of the present invention.

In a third aspect embodiments of the present invention relate to a controller for controlling a system in accordance with embodiments of the present invention. Thereby the controller is adapted for at least controlling the at least one conversion block of the system, such that in a first mode the system can lock onto an incoming NRZ signal, and in the second mode the system can lock onto an incoming poly-binary signal.

In embodiments according to the present invention the controller may control the threshold voltages of the amplifiers. The controller may also control one or more switches which allow to force the output of one or more of the amplifiers to zero. The controller may also be able to switch the amplifier and/or the phase detection circuit on and off.

In embodiments of the present invention the controller comprises a memory storage device for storing software code allowing the controller to control the system.

In a fourth aspect embodiments of the present invention relate to a method for controlling the conversion blocks of a system in accordance with embodiments of the present invention, such that in the first mode the system can lock onto an incoming NRZ signal, and in the second mode the system can lock onto an incoming poly-binary signal.

In embodiments of the present invention the method may comprise setting the threshold levels of the different amplifiers.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic overview of a system for recovering a clock signal from an incoming signal in accordance with embodiments of the present invention.
FIG. 2 shows a schematic overview of a system for recovering a clock signal and a data signal from an incoming signal in accordance with embodiments of the present invention. The systems comprises comparators for conditioning the incoming signal.
FIG. 3 shows a diagram of the signals on different nodes of the system illustrated in FIG. 2 in accordance with embodiments of the present invention.
FIG. 4 also shows a diagram of the signals and illustrates the effect of a late clock and the effect of an early clock, in accordance with embodiments of the present invention.
FIG. 5 shows an eye-diagram of a duo-binary input signal and an eye-diagram of a NRZ input signal, and the corresponding threshold levels, in accordance with embodiments of the present invention.
FIG. 6 shows an eye-diagram with four vertical eyes (five-level polybinary), and the corresponding threshold levels, in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect embodiments of the present invention relate to a system 100 for recovering a clock signal 160 from an incoming signal 150. The system comprises at least two phase detection circuits 130, and at least one conversion block 120 per phase detection circuit 130. The conversion blocks 120 are adapted for conditioning the incoming signal. The incoming signal 150 is a poly-binary signal or an NRZ signal.

In embodiments of the present invention the system 100 is configured for deriving the clock signal 160 from the poly-binary signal or NRZ signal by controlling the at least one conversion block 120 and/or by controlling the phase detection circuits 130, such that in a first mode the system 100 can lock onto an incoming NRZ signal, and in a second mode the system 100 can lock onto an incoming poly-binary signal.

In embodiments of the present invention the phase detection circuit 130 is adapted for detecting the phase of an incoming NRZ signal.

In the first mode, the conversion blocks may be set such that the incoming NRZ signal is received at the input of only one of the phase detection circuits and/or the output of all but one phase detection circuit may be set to zero.

In the second mode, the conversion blocks may be set such that an incoming poly-binary signal is converted by the different conversion blocks into different NRZ signals corresponding with different vertical eye openings of the incoming poly-binary signal. The resulting NRZ signals can then be selected by the different phase detection circuits 130.

In embodiments of the present invention the system 100 comprises an output block 140 adapted for combining the outputs of the phase detection circuits 130 to generate the clock signal.

In embodiments of the present invention the system 100 is adapted for using the clock signal or a signal synchronous with the clock signal for clocking the phase detection circuits 130. In embodiments of the present invention the clocking of the phase detection circuits 130 may be done using a divided or multiplied version of the clock signal.

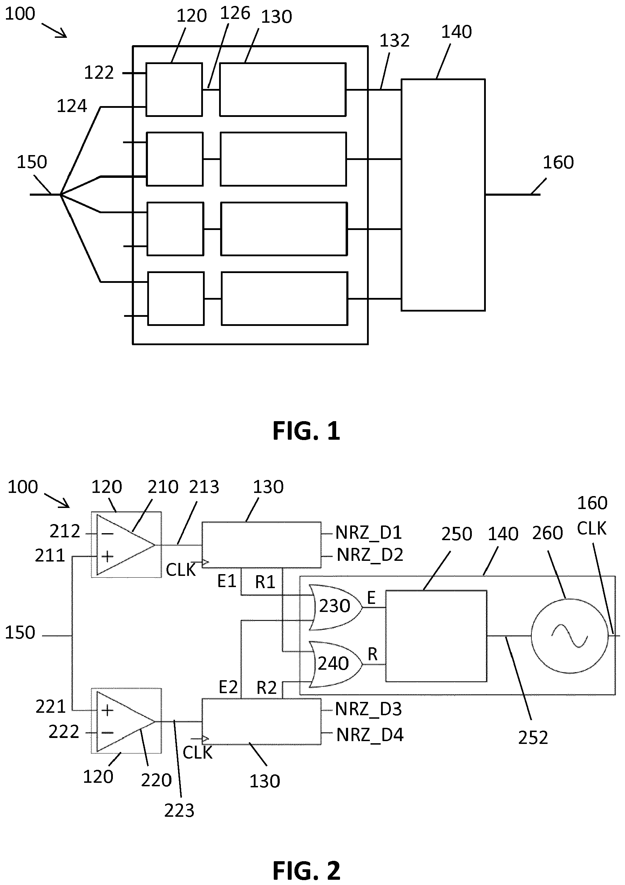

FIG. 1 shows a schematic overview of a system 100 in accordance with embodiments of the present invention. The figure shows a number of conversion blocks 120, the conversion blocks comprising a first input terminal 124 to which the incoming signal 150 can be connected. In this exemplary embodiment of the present invention the conversion blocks comprise a second input terminal 122 which can be used to set the conversion blocks such that they can perform at least one of the following functions: to pass an incoming NRZ signal to its output 126, to block an incoming signal, to convert a poly-binary signal into an NRZ signal corresponding with a vertical eye opening of the poly-binary signal. The output 126 of each conversion block 120 is connected with the input of a phase detection circuit 130. The phase detection circuits 130 are NRZ phase detectors. It is an advantage of embodiments of the present invention that the conversion blocks can convert an incoming poly-binary signal into a NRZ signal. The outputs 132 of the phase detection circuits 130 are connected with an output block 140. This output block 140 is adapted for combining the outputs of the phase detection circuits 130 to generate the clock signal.

An exemplary embodiment of a system 100 adapted for recovering a clock signal from an incoming signal and for recovering the data of the incoming signal is illustrated in FIG. 2.

In this exemplary embodiment of the present invention the system 100 comprises conversion blocks 120, phase detection circuits 130, and an output block 140. Each of the phase detectors 130, in this exemplary embodiment of the present invention, is adapted for delivering an error and reference signal (E1, R1, E2, R2). The error signal is proportional with the phase difference between the clock (CLK) and the incoming NRZ signal, more importantly the integral over time of the error signal gives half the value of the integral of the reference signal over time in case the phase of the clock is correct (this is the case of this specific phase detector, other types of phase detectors will return error pulses of which the integral equals the integral of the reference signal of perfect clock phase, in general the comparison of the integral over time of the error and reference signal gives an indication of the phase). In embodiments of the present invention the reference signal itself does not changes with the clock phase but is simply shifted but is necessary to compare the error signal to. The integration of both the error and reference signal is what is done by the combination of charge pump and loop filter.) The used phase detection circuits 130 may have a topology as described in "A 10-Gb/s CMOS Clock and Data Recovery Circuit with a Half-Rate Linear Phase Detector", IEEE JOURNAL OF SOLID-STATE CIRCUITS, VOL. 36, NO. 5, MAY 2001, Jafar Savoj and Behzad Razavi.

The conversion blocks 120 may comprise comparators 210, 220. In the exemplary embodiment illustrated in FIG. 2 a first conversion block 120 comprises a first comparator 210 and a further conversion block comprises a further comparator 220. The first input terminals 211, 221 of the first and of the further comparator 210, 220 are adapted to be connected with the incoming signal. The second input terminals are adapted to be connected with a threshold signal. By controlling the threshold signal, the output of the comparator can be controlled.

In embodiments of the present invention, per set of conversion blocks 120 an upper threshold signal is connected with a second input terminal 212 of the first comparator 210, and a lower threshold signal is connected with a second input terminal 222 of the further comparator 220. The comparator can for example be an amplifier. The threshold signal can be a threshold voltage at one input terminal (e.g. the negative terminal) of the amplifier and the incoming signal can be an incoming voltage at the other input terminal (e.g. the positive terminal) of the amplifier. The polarities of the terminals are only exemplary and the invention is not limited thereto.

The system 100, illustrated in FIG. 2, can for example be used to extract the clock of a NRZ signal or of a poly-binary signal (e.g. duo-binary signal).

When receiving an NRZ signal, one of the threshold signals may be set either completely above or completely below the incoming signal level such that the phase information of the corresponding phase detection circuit is constant. The remaining threshold may be set at zero so that the output of the corresponding comparator is the incoming NRZ signal and the input of the corresponding phase detection circuit equals the input NRZ signal.

When receiving a poly-binary signal the threshold signal of one or more of the comparators can be set such that the poly-binary signal is converted in a NRZ signal which can be selected by the corresponding phase detection circuit 130.

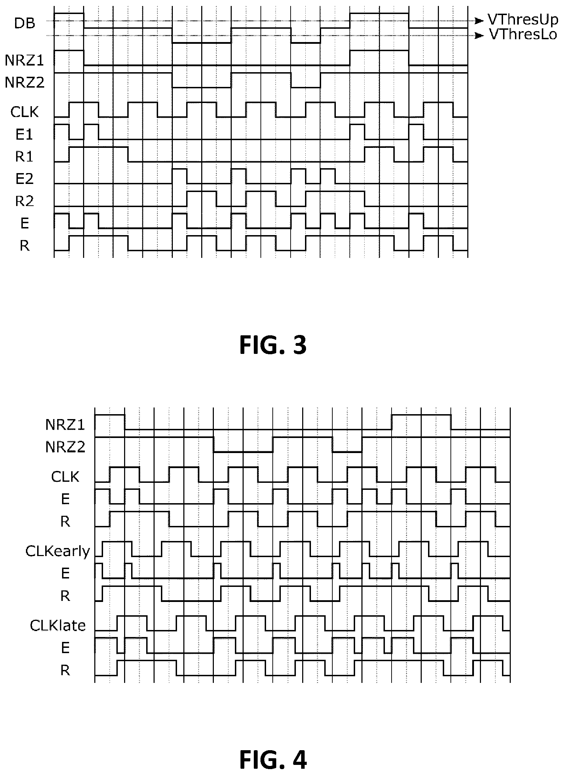

In this exemplary embodiment of the present invention the output block 140 comprises combiners 230, 240, a charge pump 250 and a voltage controlled oscillator 260. The error signals (E1, E2) from the phase detectors are combined using a first combiner 230 to generate an overall error signal (E) and the reference signals (R1, R2) from the phase detectors are combined using a second combiner 240 to generate an overall reference signal (R). These combiners may for example be OR-gates. Due to the specific properties of poly-binary signals, as illustrated in FIG .3, XOR-gates can also be used. If one of the two NRZ streams has a transition the other can't have a transition if these NRZ signals correspond to the two vertical eyes, due to the nature of duobinary (this is not the case with non-polybinary signals like e.g. PAM4). Because of this the two error and reference signals are never high at the same time, as can be seen in FIG. 3. In this case a XOR operation is identical to an OR operation. Other combination such as single-gate (single-gate points merely to the use of a single digital block, e.g. an OR-gate), or even more complex gates may also be used. In embodiments of the present invention the outputs of the combiners 230, 240 are used in the charge pump 250 which together with a loop filter generates the tuning voltage 252 for the voltage controlled oscillator (VCO) 260 which realizes the clock signal 160 (CLK).

In embodiments of the present invention the system 100 is adapted for recovering the data of the incoming signal. In embodiments of the present invention this is done by using the generated clock to sample the NRZ streams after the conversion blocks (120). The sampled NRZ streams may then be combined to obtain the incoming signal (e.g. by means of XOR gates).

In the exemplary embodiment of the present invention, illustrated in FIG. 2, the loop filter is an analog filter. The charge pump and loop filter block 250, however, could be replaced by a digital loop filter, where no charge pump is used. This may result in a more complex combination of E and R pulses. In embodiments of the present invention the output of the phase detection circuit 130 is not necessarily E and R, but could be a binary decision too (e.g. bang-bang CDR).

In the exemplary embodiment of the present invention, illustrated in FIG. 2, the output block 140 comprises a VCO. In other embodiments of the present invention this could be a DCO (digitally controlled oscillator) that is not controlled by a voltage, but by a digital word.

In general, the charge pump and loop filter 250 and the VCO 260 in FIG. 2 may be replaced by any technique known for a traditional NRZ CDR.

Moreover, in embodiments of the present invention the phase detection circuits 130 may be adapted to generate "early" and "late" pulses which can be combined by combiners 230, 240 to result in a single "early" and "late" pulse. After the combiners, the output block may comprise the components of a traditional NRZ CDR system.

In embodiments of the present invention the phase detection circuit 130 is adapted for performing the function of de-multiplexing. This allows the demodulation of the poly-binary data-stream at a lower bitrate. In case of a duo-binary data-stream this results in a needed clock speed which is only half this of the duo-binary bitrate which allows implementation with a lower power consumption.

It is an advantage of embodiments of the present invention that the system 100 for recovering the clock signal from an incoming signal is capable of switching between recovering a clock signal from a poly-binary (e.g. duo-binary) signal and recovering a clock signal from a NRZ-signal. This can be done by switching between the first mode and the second mode of the system 100. It is an advantage of embodiments of the present invention that the system can lock onto duo-binary and NRZ signals.

The number of conversion blocks is not limited to 2 as in the example of FIG. 2. For example, in case of a five level poly-binary signal, a system 100 comprising 4 conversion blocks 120 may be used. In that case the 4 thresholds signals may each time be set in the middle of the four vertical eyes. In embodiments of the present invention the threshold signals are not set in the middle as sometimes it is more important to have wider eye, in case jitter is the limiting factor, instead of having more margin to the top and bottom of the eye. In embodiments of the present invention the threshold is set as to achieve the best trade-off between jitter tolerance and noise/crosstalk tolerenace. This will result in 4 different but synchronous NRZ streams at the output 126 of the conversion blocks 120. These outputs may be connected with phase detectors 130 which may generate four streams of phase information which can be combined in output block 140 (in that case the combiner may for example be a four-way OR-function). The output block 140 may comprise a combiner for the phase information, a charge pump and loop filter. In case of a five level poly-binary signal also less than 4 phase detectors may be used, however, this will result in a loss of phase information.

When receiving an NRZ signal in a system 100 comprising 4 conversion blocks, three threshold signals may be set either completely above or completely below the incoming signal such that the phase information of three of the phase detection circuits equals a constant value. In embodiments of the present invention this may be a zero value. The remaining threshold is set at zero so that the input of the remaining phase detector equals the input NRZ signal 150 and the phase information of this phase detector is combined with the constant value of the other phase detectors which in case of an OR and a zero for the constant value, means that the phase information of this single phase detector is used for locking the clock.

FIG. 3 shows a duo-binary input signal 150. It shows the NRZ signals (NRZ1, NRZ2) corresponding with the outputs 126 of the conversion blocks 120. It shows the signals NRZ_D1 and NRZ_D2 which are the demultiplexed NRZ streams corresponding to NRZ1, and NRZ_D3 and NRZ_D4 which are the demultiplexed NRZ streams of NRZ2. It shows the error and reference signals (E1, E2, R1, R2) generated by the phase detection circuits, the combined error and reference signals (E, R) and the clock signal (CLK) 160 at different nodes of the system 100 illustrated in FIG. 2. In this example the system is operated in the second mode thereby locking onto the incoming duo-binary signal for recovering the clock signal. The error pulses (E) generated are half the length of the reference pulses (R) if the clock edge is at the wanted position (halfway the incoming bits). In this case no charge is pumped into the loop filter.

When, in the system 100 illustrated in FIG. 2, the clock (CLK) is early, the error pulses (E) become shorter while a late clock will result in longer error pulses (E). This is illustrated in FIG. 4 showing the NRZ signals (NRZ1, NRZ2) generated by the phase detection circuits 130, the clock signal (CLK) if the clock edge is at the wanted position, the clock signal (CLKearly) if the clock is early, the clock signal (CLKlate) if the clock is late, and the corresponding error (E) and reference (R) pulses. This difference in pulse length of the error pulses (E) is used in the charge pump to sink or source current in the loop filter 250 controlling the Vtune voltage 252 of the VCO 260.

The system 100, according to embodiments of the present invention, may also operate in the first mode and lock onto an incoming NRZ signal for recovering a clock signal from the incoming NRZ signal. When receiving an NRZ signal 150 in the system 100 of FIG. 2 this may be done by setting the threshold signals 212, 222 of one of both amplifiers 210, 220 to zero while the error and reference signals of the phase detection block 130 associated with the other amplifier are forced to zero. This can be done either by forcing these signals to ground with a switch, by biasing the threshold of the associated amplifier past the maximum/minimum of the input NRZ stream or by switching off either or both the associated amplifier and the phase detection block.

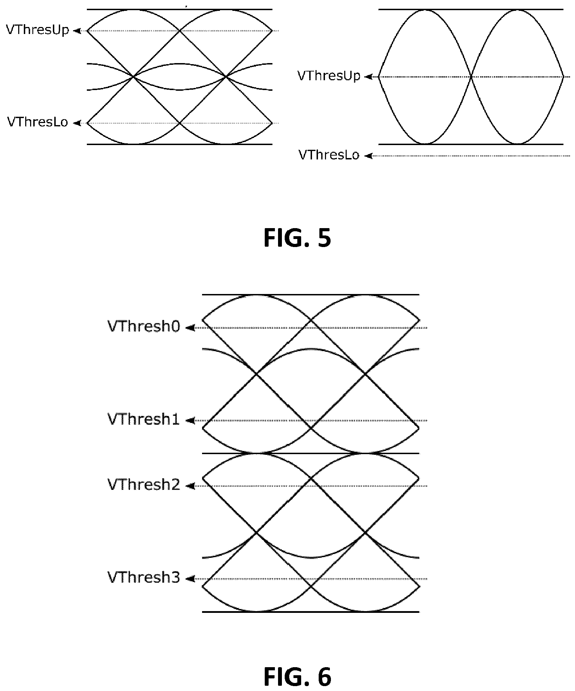

An example of the threshold levels of the second inputs 212, 222 of the amplifiers 210, 220 of a system 100 as illustrated in FIG. 2 is shown in FIG. 5. The graphs show possible threshold levels when the system is in the first mode for clock and data recovery of a NRZ signal, and when the system is in the second mode for clock and data-recovery of a duo-binary signal. The left graph shows possible threshold levels in the second mode in case of a duo-binary input stream. It shows VThreshUp which may be applied at the second input terminal 212 of the first amplifier 210 and VThreshLo which may be applied at the second input terminal 222 of the second amplifier 220. The right graph shows possible threshold levels in the first mode in case of a NRZ input stream. It shows VThreshUp which may be applied at the second input terminal 212 of the first amplifier 210 and VThreshLo which may be applied at the second input terminal 222 of the second amplifier 220.

An example of the threshold levels VThresh0, VThresh1, VThresh2, VThresh3 for an eye-diagram with four vertical eyes (five-level polybinary), is illustrated in FIG. 6. In a second aspect embodiments of the present invention relate to a receiver comprising a system for recovering a clock signal in accordance with embodiments of the present invention.

In a third aspect embodiments of the present invention relate to a controller for controlling a system for recovering a clock signal in accordance with embodiments of the present invention. The controller is adapted for controlling the at least one conversion block 120 of the system 100, such that in a first mode the system can lock onto an incoming NRZ signal, and in the second mode the system 100 can lock onto an incoming poly-binary signal and such that the system can recover a clock signal from the incoming signal.

The controller may set the conversion blocks, it may for example control the second input terminals 122 of the conversion blocks 120. It may for example control the threshold signals at the second input terminals of the comparators. The controller may also control the phase detection circuits (e.g. to switch on/off their outputs).

The controller may comprise a memory storage device for storing software code allowing the controller to control the system 100.

In a fourth aspect embodiments of the present invention relate to a method for controlling the conversion blocks of a system for recovering a clock signal in accordance with embodiments of the present invention, such that in a first mode the system 100 can lock onto an incoming NRZ signal, and in the second mode the system 100 can lock onto an incoming poly-binary signal.

The method may comprise setting the conversion blocks, it may for example comprise controlling the second input terminals 122 of the conversion blocks 120. It may for example comprise controlling the threshold signals at the second input terminals of the comparators. The method may also comprise controlling the phase detection circuits (e.g. to switch on/off their outputs).

## Claims

1. A system (100) for recovering a clock signal (160) from an incoming signal (150), the system comprising at least two phase detection circuits (130), and at least one conversion block (120) per phase detection circuit (130) wherein the conversion blocks are adapted for conditioning the incoming signal,
wherein the incoming signal (150) is a poly-binary signal or an NRZ signal,
and wherein the system (100) is configured for recovering the clock signal (160) from the poly-binary signal or NRZ signal by controlling the at least one conversion block (120) and/or by controlling the phase detection circuits (130), such that in a first mode the system (100) can lock onto an incoming NRZ signal for recovering the clock signal, and in a second mode the system (100) can lock onto an incoming poly-binary signal for recovering the clock signal.

2. A system (100) according to claim 1, wherein in the first mode the system (100) can set the conversion blocks (120) such that the NRZ signal is received at the input of only one of the phase detection circuits (130), and/or wherein the system (100) can set the output of all but one phase detection circuit (130) to zero,
and wherein in the second mode the system (100) can set the conversion blocks (120) such that the poly-binary signal, comprising different vertical eye openings when represented in an eye diagram, can be converted by the different conversion blocks into different NRZ signals corresponding with the different vertical eye openings, such that the resulting NRZ signals can be selected by the phase detection circuits (130),
wherein the system comprises an output block (140) for combining the outputs of the phase detection circuits (130) to generate the clock signal,
and
wherein the system (100) is configured such that, in operation, the clock signal or a signal synchronous with the clock signal is used for clocking the phase detection circuits (130).

3. A system (100) according to any of the previous claims, wherein the phase detection circuits (130) are adapted for also performing the function of de-multiplexing.

4. A system (100) according to any of the previous claims, wherein the conversion blocks (120) comprise a comparator (210, 220), and wherein the incoming signal (150) can be connected with a first input terminal (211, 221) of the comparator (210, 220) and a threshold signal can be connected to a second input terminal (212, 222) of the comparator (210, 220),
wherein in the first mode the system can set the threshold signals of the comparators such that the NRZ signal is received at the input of one of the phase detection circuits, and/or wherein in the first mode the system (100) can force the output of the other comparators to zero and/or the output of the corresponding phase detection circuit (130) to zero,
wherein in the second mode the system (100) can set the threshold signal of one or more of the comparators such that the poly-binary signal is converted in a NRZ signal which can be selected by the corresponding phase detection circuit (130),
wherein the system (100) comprises an output block (140) for combining the outputs of the phase detection circuits (130) to generate the clock signal (160).

5. A system (100) according to claim 4, the system comprising one or more switches which allow to force the output of one or more of the comparators (210, 220) to zero.

6. A system (100) according to claim 4, wherein the system is adapted for biasing the threshold signal of one or more of the comparators (210, 220) past the maximum or minimum of the NRZ signal to force the output of one or more of the comparators to zero.

7. A system (100) according to any of the claims 4 to 6, wherein the system is adapted for switching off the comparator (210, 220) and/or the phase detection circuit (130).

8. A system (100) according to any of the previous claims wherein the phase detection circuits (130) are adapted for delivering an error and a reference signal and wherein the output block (140) comprises a first combiner (230) adapted for combining the error signals of phase detectors (130) and a second combiner (240) adapted for combining the reference signals of the phase detectors (130).

9. A system (100) according to claim 8 wherein the output block (140) comprises a charge pump and loop filter (250) and a voltage controlled oscillator (260) wherein the inputs of the charge pump and loop filter (250) are connected with the outputs of the combiners (230, 240) and wherein the charge pump and loop filter (250) are adapted for generating a tuning voltage, based on the outputs from the combiners (230, 240), for the voltage controlled oscillator (260).

10. A system (100) according to any of the previous claims wherein the system (100) is adapted for recovering the data of the incoming signal (150).

11. A system (100) according to any of the previous claims wherein the poly-binary signal is a duo-binary signal.

12. A receiver comprising a system (100) according to any of the previous claims.

13. A controller for controlling a system (100) in accordance with any of the claims 1 to 11, by at least controlling the at least one conversion block (120) of the system (100), such that in a first mode the system (100) can lock onto an incoming NRZ signal, and in the second mode the system (100) can lock onto an incoming poly-binary signal.

14. A controller according to claim 13, the controller comprising a memory storage device for storing software code allowing the controller to control the system (100).

15. A method for controlling the conversion blocks of a system (100) in accordance any of the claims 1 to 10, such that in the first mode the system (100) can lock onto an incoming NRZ signal, and in the second mode the system (100) can lock onto an incoming poly-binary signal.
